Europäisches Patentamt

European Patent Office

Office européen des brevets

(11) Publication number: 0 388 311
A2

## EUROPEAN PATENT APPLICATION

(21) Application number: 90400716.8

(22) Date of filing: 16.03.90

(51) Int. Cl.5: H01L 23/12, H01L 23/495

(30) Priority: 17.03.89 JP 63779/89

(43) Date of publication of application:
19.09.90 Bulletin 90/38

(84) Designated Contracting States:
DE FR GB IT NL

(71) Applicant: FURUKAWA DENKI KOGYO
KABUSHIKI KAISHA
6-1 Marunouchi 2-chome
Chiyoda-ku Tokyo(JP)

Applicant: SEIKO EPSON CORPORATION
4-1, Nishishinjuku 2-chome
Shinjuku-ku Tokyo(JP)

(72) Inventor: Ohtani, Kenichi, c/o Furukawa Denki
Kogyo K.K.
Yokohama Kenkyusho, 2-4-3, Okano, Nishi-ku
Yokohama-shi, Kanagawa(JP)
Inventor: Kamimura, Masaru c/o Seiko Epson
Corporation
3-5, Owa 3-chome
Suwa-shi, Nagano(JP)

(74) Representative: Schrimpf, Robert et al
Cabinet Regimbeau 26, Avenue Kléber
F-75116 Paris(FR)

(54) Chip Carrier.

(57) A chip carrier for mounting semiconductor device chips thereon. The chip carrier includes a flexible tape (2) and metal wires (1) formed on the surface of the flexible tape. Each of the metal wires includes an inner lead portion (1a) and the inner lead portions are supported by the flexible tape. The flexible tape is formed with an opening (3) in an area thereof inside the forward ends of the inner lead portions.

FIG.1

EP 0 388 311 A2

EP 0 388 311 A2

## CHIP CARRIER

## BACKGROUND OF THE INVENTION

### 1. Field of the Invention

The present invention relates to a chip carrier which is used when connecting the terminals of a semiconductor chip such as an IC or LSI to the terminals of an external container (so-called package) or circuit board.

### 2. Description of the Prior Art

In the past, it has been the practice to connect the plurality of connection pads or bumps of a semiconductor device chip to a lead frame or the terminals of a circuit board by means of bonding wires or the lead wires formed on a film chip carrier of a tape form, patch type or the like. In this case, the distinction in use application between the bonding wires and the film chip carrier is dependent upon the pitch between the bumps of the semiconductor device chip so that if the pitch is less than 200 to 300 $\mu$m, for example,the film chip carrier is generally used.

In a known type of film chip carrier, a plurality of device foils for semiconductor device chips mounting purposes are formed in an electrically insulating flexible film made of a polyimide film or polyester film and a plurality of metal wires (lead wires) are formed on the peripheral edges of the device opening on one side of the flexible film in such a manner that a plurality of inner leads are radially extended over th device opening.

The inner leads of the lead wires are extended in an overhanging manner over the device opening so that after a semiconductor device chip has been mounted in the device hole, the inner leads and the bumps of the semiconductor device chip are bonded under the application of pressure.

Then, recently there has been a marked tendency toward increasing the level of integration of semiconductor device chips with the resulting increase in the number of input/output connection pads and presently semiconductor device chips having bump pitches of less than 100 $\mu$m have come to the stage of practical use.

However, it is extremely difficult to manufacture a film chip carrier having the inner leads of fine pitches which conform with semiconductor device chips having such extremely small bump pitches.

In other words, the ordinary method of forming the metal wires of a chip carrier comprises depositing a copper foil of about 35 $\mu$m on a flexible film member by evaporation or the like or applying such copper foil onto a flexible film member and then etching the copper foil to form the metal wires or alternatively the method is such that a catalytic active layer with respect to an electroless plating is formed in a desired wiring pattern on the surface of a flexible film member and then copper plating is applied, to form the metal wires. However, where the inner lead pitch must be made extremely small, the following difficulties are encountered.

In the case of the former etching process, if the desired inner lead pitch is selected 70 $\mu$m, the width of conductors for the inner leads becomes about 35 $\mu$m. Thus, if the thickness of the copper foil layer is 35 $\mu$m, the width/thickness ratio of the conductor becomes less then 1 so that the side etching occurs in a marked degree and thus the cross-sectional shape of the inner lead of each metal wire becomes trapezoidal.

Also, in the case of the latter plating process, there is the possibility of causing lumps to project in the pitch direction from the laminated plated layer thus causing a short circuit between the metal wires and there are instances where the size of such lumps becomes about 20 $\mu$m if the copper foil thickness is 35 $\mu$m, for example.

To overcome these deficiencies, in either of these processes it is desirable to reduce the thickness of the metal wires. In other words, if the thickness of the copper foil layer is small in the method employing the etching, the side etching is prevented from proceeding considerably and the metal wires having substantially a rectangular shape in cross-section are produced. Also, if the plating thickness is small in the method employing the plating, lumps are not grown much and there is less danger of a short-circuit being caused.

2

However, since the inner leads of the metal wires on the conventional chip carrier have the overhanging structure projecting over the opening of the device hole as mentioned previously, the metal wires must independently withstand the pressure applied for the bonding of the metal wires and the semiconductor device chip.

While it is believed that this withstand pressure (hereinafter referred to as a "finger strength") must be between 5 and 15g, if the copper foil layer is reduced in thickness so that the copper foil wire has for example a width of 25 μm and a thickness of 18 μm, its finger strength becomes 12g and there are instances where the metal wires with such reduced thickness cannot withstand the bonding of the semiconductor device chip, thereby deteriorating the reliability of products.

## SUMMARY OF THE INVENTION

It is the primary object of the present invention to provide a chip carrier which ensures finer metal wires of a sufficient finger strength and is excellent in bonding processing characteristics and durability.

To accomplish the above object, in accordance with an aspect of the present invention there is thus provided a chip carrier in which a plurality of groups of metal wires each including an inner lead connected to one of the terminals of a semiconductor device chip to be mounted are formed on one side of a flexible film member so as to extend radially toward the chip mounting area. The metal wires each including at least one of the inner leads are formed on the flexible film member and the flexible film member is formed, in its limited first area including the inner leads, with an opening in the portion between the metal wires and on the inner side of the forward ones of the inner leads.

In accordance with another aspect of the present invention, the chip carrier is designed so that the film thickness of the flexible film member is reduced on the opposite side to be metal wire containting side in a second area surrounding the opening and containing the inner leads and the second area is small in film thickness relative to a third area of the film member surrounding the second area.

In accordance with one form of the chip carrier of the present invention, the film member is in the form of a flexible tape of a continuous length and a plurality of rows of chip mounting areas are arranged and the metal wires are arranged at each of the mounting areas. In accordance with another form, the film member has the form of a patch type separated for every one or more chip mounting areas. In this case, the first area is one including an area (area A) enclosed by the forward ends of the inner leads and an area (area B) where at least the inner leads of the metal wires are in the flexible film member, and the opening formed in the first area may be such that a space (where the film member is not present) is formed in each of the area A and the portion between the metal wires (the parts including at least the inner leads) formed in the area B.

On the other hand, the second area may be such that it includes and extends to the outer side of the area A but is limited to the inner side of the whole area where the metal wires are formed (the area enclosed by the outer leads or the outer forward end portions of the metal wires) and a third area of the ordinary film thickness is present to surround the second area. Depending on circumstances, the second area may be the same area as the first area.

In the chip carrier according to the present invention, the inner leads of the metal wires are such that the whole lengths of the inner leads are formed on the flexible film member in contrast to the conventional metal wires each having an overhanging structure. As a result, the flexible film member supports and reinforces the inner leads up to their forward ends so that even if the metal wire itself is reduced in thickness, the metal wire can satisfactorily withstand the application of heat and pressure during the bonding operation from the strength point of view. Thus, the metal wires can be reduced in thickness without decreasing the finger strength and the metal wires can be made ultrafine to such extent which has never been possible in the past.

Also, since the inner leads are reinforced by the flexible film member, there is the less danger of causing such troubles as deformation of the inner leads due for example to the contacting of the inner leads with any other object and shortcircuiting due to contacting of the adjacent inner leads caused by the disordered arrangement of the forward ends thereof. Particularly, where the present invention is applied to a tape carrier, the orderly arrangement of inner leads is maintained during the interval between the manufacture of a tape carrier and the time of bonding of each semiconductor device chip and the inner leads.

In addition, the chip carrier according to the present invention includes the opening formed in the first area such that the opening is present in the area between the adjoining metal wires, particularly between the inner leads and inner side of the forward ends of the inner leads. In this connection, while it is desirable that in the first area the planar shape of the flexible film member reinforcing and supporting the metal wires are the same with the shape of the metal wires, particularly the shape of at least the inner leads, the planar shape may be greater. In other words, it is only required that in the first area the flexible film member does not extend over the metal wires but forms a space between the metal wires.

The reason is that by forming the opening between at least the inner leads of the metal wires, each of the inner leads is made independent electrically and structurally in the connection pad pitch direction of the semiconductor chip.

The opening has the effect of eliminating the effect of a thermal stress caused by the difference in coefficient of thermal expansion between the metal wires and the flexible resin member with respect to at least the pad pitch direction.

Also, in accordance with the present invention the formation of the opening has the effect of forming a space where no flexible film member is present. Thus, this is also advantageous from the standpoint of preventing the inpurity ions contained in the flexible film member from migrating to the semiconductor device chip and thereby damaging the semiconductor device chip.

Further, in accordance with the present invention, in the second area the thickness of the flexible film member supporting the metal wires is reduced so far as the desired finger strength is obtained so that the thermal stress due to the difference in coefficient of thermal expansion between the flexible tape member and the metal wires is further reduced with respect particularly to the wire lengthwise direction.

As a result, the danger of causing thermal deformation, etc., of the inner leads is reduced further and very excellent bonding processing performance is ensured, thereby reducing the danger of the occurrence of fatigue failure, etc., of the connected portions due to their thermal changes after the connection.

Still further, in accordance with the present invention the thickness of the flexible film member in the third area is maintained in the same manner as the conventional chip carrier with the result that the required film strength, such as, the strength required for the chip carrier for sprocket feeding purposes, etc., can be maintained. Particularly, in the case of the tape carrier, the tape take-up operation and other handling operations performed during the interval between the time of the tape manufacturing and the time of bonding it to the semiconductor device chips are easy.

It is to be noted that if the first area is formed as an area corresponding to the conventional device hole forming area, the opening can be provided with the same function as the conventional device hole. Also, the first area can be formed as an area including for example the outer leads of the metal wires. In this case, while the opening is formed to extend over a wider portion than the conventional device hole perforated portion, each of the metal wires is reinforced and supported by the flexible film member and the required strength for each lead is ensured.

In this case, it is possible to support the adjoining metal wires in common by the suitable bridge (the film member).

On the other hand, if necessary, the flexible tape member may be removed or its thickness may be reduced to form a thinner portion with respect to the limited area containing the outer leads independently of the first area.

This area represents the problem encountered when a semiconductor chip which has been mounted and made into a semiconductor device on the tape carrier is connected to the terminals of an external circuit device or the like. For example, when bonding and electrically connecting the outer leads directly to the terminals by a mechanical device or the like, it is desirable to form a thin film portion in the limited area to increase the finger strength of the outer leads. Also, when marketing as the ordinary semiconductor device, if, for example, the arrangement of the terminals on an external circuit device differs from the arrangement of the outer leads or if the joining positions are on the back surface side, there are instances where the flexible film member is not formed in the area containing the outer leads in consideration of the bending properties, electrical joining conditions, etc., of the outer leads.

Then, the thickness of such flexible film member can be selected separately in consideration of the film strength required for a chip carrier, the previously mentioned finger strength, the bending properties during bonding or in use, etc. For example, the bending properties may be ensured by reducing only the bent portions in thickness or by removing the film member.

Also, where a thinner portion is provided separately for each of the inner leads and the outer leads, the portion of the ordinary film thickness is left between the inner leads and the outer leads and this portion may be provided with the function as a support ring.

As described hereinabove, the chip carrier according to the present invention can be reduced in section thickness thus enabling to make finner the width and pitch of the metal wires.

This permits to meet the requirements for the mounting of semiconductor device chips having

4

extremely small pin pitches and thus this is very useful in view of the ever increasing tendency toward a markedly high integration level of semiconductor device chips.

In addition, by using this chip carrier in combination with semiconductor decvice chips so as to make products as semiconductor devices, it is possible to reduce the work and cost and also the occurrence of defective units is reduced, thereby reducing the product cost.

The manufacturing method of the tape carrier according to the present invention is as follows. It is to be noted that the following method is an example and the invention is not limited thereto.

First, a coating of metal (e.g., copper, chromium or nickel) of 0.1 to 1 $\mu$m thick is formed by a sputtering/evaporation process on one side of a flexible film member of about 10 to 200 $\mu$m thick which is made from a material having excellent heat resisting properties such as polyimide, polyphenylene sulfide, polyethylene terephthalate or liquid crystal polymer.

Then, if necessary, copper plating is applied to form a 1 to 20 $\mu$m metal foil layer mainly composed of copper and then the metal foil layer is etched thereby forming metal wires or alternatively metal wires are formed by applying, after the formation of the metal coating, copper plating to the metal coating with the undesired portion being masked (the masking is effected with a negative pattern) and then flash etching the metal coating.

Thereafter, the portion of the flexible film member having no metal wires formed thereon is removed by etching or the like with respect to a first area and an opening is formed in an area lying between the metal wires and inside the forward ends of inner leads. At this time, if necessary, the flexible film member is partially removed by etching or the like from the side (the back side) having no metal wires formed thereon.

Then, where the flexible film member must be formed with a thin-section portion with respect to a second area, the flexible film member is partly removed from the back side with respect to the area remaining after exclusion of the opening from the second area thereby forming a thin-section portion of a given thickness in the second area.

Alternatively, it is possible to preliminarily reduce partly the flexible film member in the second area from the back side prior to the formation of an opening in the first area and then form the opening in the first area.

Here, the known methods of reducing the thickness of the flexible tape member composed of a high-molecular film include for example a plasma etching process as one form of the dry etching method. According to this method, a gas plasma activated by an ECR plasma or the like is sprayed onto the surface to be etched thereby removing the high molecular film in that portion.

Also, where the flexible tape member is composed of a polyimide film, the desired results can be obtained by a wet etching process using for example a mixed solution of hydrazine and ethylenediamine or a solution prepared by solvimg an alkaline chemical, e.g., potassium hydroxide in ethanol or water.

Then, it is desirable that the thin film portion formed in the second area of the flexible tape member has a thickness of greater than about 5 $\mu$m in order to ensure a sufficient finger strength for the inner leads of the metal wires, and also it should preferably be the same or smaller in thickness than the metal wires so as to prevent deformation of the inner leads due to a thermal stress.

For instance, where the flexible tape member is composed of a polyimide film, the thickness should preferably be in the range of 5 and 25$\mu$m from the finger strength point of view.

It is to be noted that where the flexible tape member is removed entirely or a thin-section portion is formed in the area containating the outer leads, for example, the required operation can be performed in accordance with the above-mentioned method.

### BRIEF DESCRIPTION OF THE DRAWINGS

Fig.1 is a partial plan view of a tape carrier according to a first embodiment of the present invention.
Fig.2 is a partial sectional view of the tape carrier according to the first embodiment of the invention.
Fig.3 is a partial sectional view of a tape carrier according to a second embodiment of the invention.
Fig.4 is a partial plan view of a tape carrier according to a third embodiment of the invention.
Fig.5 is a partial view of the tape carrier according to the third embodiment of the invention.

### DESCRIPTION OF THE PREFERRED EMBODIMENTS

The present invention will now be described with reference to the illustrated embodiments. While the following embodiments are each directed to a case where a tape carrier is used as a chip carrier, these embodiments substantially apply to the cases of chip carriers of single-unit patch type.

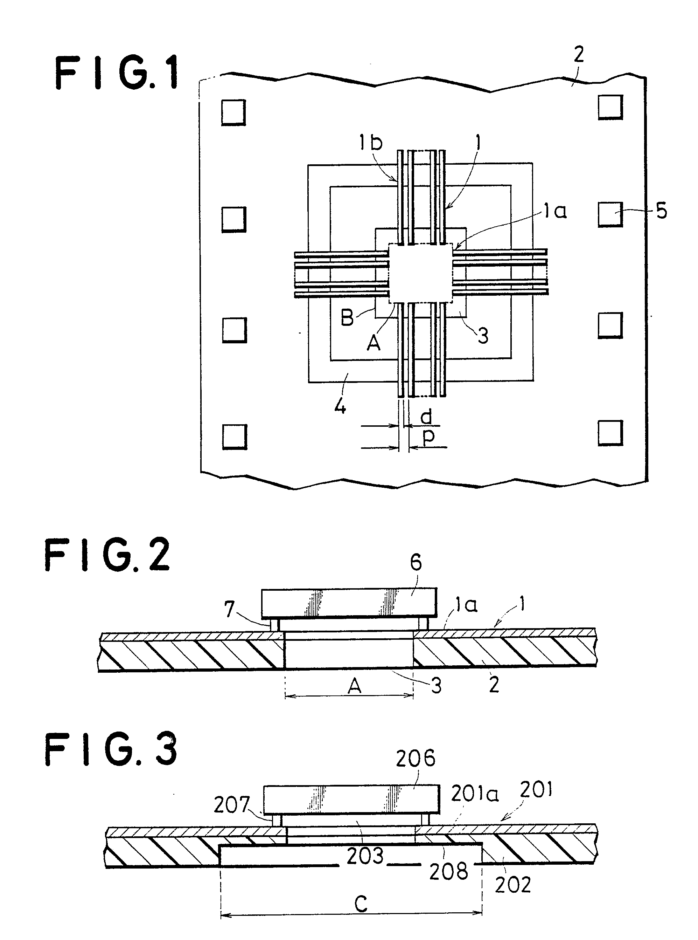

Figs.1 and 2 are respectively a partial plan view and partial sectional view of a tape carrier according to a first embodiment of the present invention.

In accordance with this embodiment, a copper film of 0.2 $\mu$m is first deposited by a sputtering/evaporation process on one side of a flexible tape 2 composed of a polyimide film of 50 $\mu$m thick and then electrolytic copper plating is applied thereby forming a copper foil layer of 10 $\mu$m thick.

Then, the copper foil layer is etched by using a ferric chloride solution thereby forming a plurality of groups of metal wires 1 of a given length in the longitudinal direction with a conductor width d = 25 $\mu$m and conductor pitch p = 50 $\mu$m. In Fig.1, the number of wires in each of the four groups of metal wires are partially omitted.

In this embodiment, the metal wires 1 are radially arranged in four directions in such a manner that arranged on the inner side are inner leads 1a which are each to be bonded to one of bumps 7 of a semiconductor device chip 6 and arranged on the outer side are outer leads 1b which are each to be connected to one of the terminals of a lead frame or external circuit board as shown in Fig.1.

Then, while, in this embodiment, each metal wire 1 is formed with the inner lead 1a and the outer lead 1b which are arranged in one-to-one correspondence and the respective outer leads 1b are connected to the terminals of an external circuit device such as a lead frame or circuit device, the invention is not limited thereto.

In other words, the metal wires formed in the tape carrier according to the invention are such that not only there are cases where the metal wires each having the inner lead at one end and the outer lead at the other end are arranged at a given pitch as shown in Fig. 1 but also there are cases where the outer leads and the inner leads are arranged in one-to-plural corresspondence and where the inner leads are connected to given circuits formed on the outer sides thereof. Further, while, in the present embodiment, each of the metal wires is formed with the single inner lead to which a simeconductor device chip is to be connected, each metal wire may be formed with a plurality of inner leads when circumstances demand.

Thereafter, an opening 3 is formed in a first area including an area A arranged on the inner side of the forward ends of the respective inner leads and an area B containing the inner leads and enclosed by the inner leads.

First, the whole sides of the flexible tape 2 are coated with an alkali-proof etching resist excluding the area A on the inner side of the forward ends of the innner leads 1a and the portion of the area B where the inner leads of the metal wires 1 are not formed. In other words, the portion on the outer side of the first area and the portion arranged on the inner side of the first area and formed with the metal wires are protected.

The tape 2 is then immersed in a potassium hydroxide solution of 5 normality at 50° C for 1.5 hours and then the tape 2 is rinsed.

As a result, the portion of the polyimide film which was not protected by the etching resist is removed and the opening 3 is formed in the area A and between the metal wires in the first area.

In this embodiment, the second area is the same area as the conventional device hole forming portion and therefore a device hole is formed by the opening 3.

It is to be noted that where the tape 2 is provided with a plurality of sprocket holes 5 arranged longitudinally in a series at a given pitch along each side thereof and an outer lead hole 4 formed in the portion corresponding to the outer leads 1b, these holes can be formed by for example coating the tape 2 with the alkali-proof etching resist excluding the portions of these holes (4,5) and then etching the resest with the same alkali type solution as used for forming the previously mentioned thin film portion to form the holes 4 and 5. However, these holes are not always required. For instance, the sprocket holes 5 are not needed if the tape can be conveyed without using any sprockets and also the outer lead hole 4 is not needed if the outer leads 1b are connected to the terminals of a circuit board or the like with the flexible tape being attached thereto.

Using the tape carrier prepared in the above-mentioned manner, as shown in the enlarged sectional view of Fig.2 showing the inner leads and the surroundings, the bumps 7 of the semiconductor device chip 6 were bonded to the inner leads 1a with the result that due to the inner leads 1a being reinforced and supported by the flexible tape 2, the inner leads 1a were not bent by the application of a pressure during the bonding and the bonding performance was excellent.

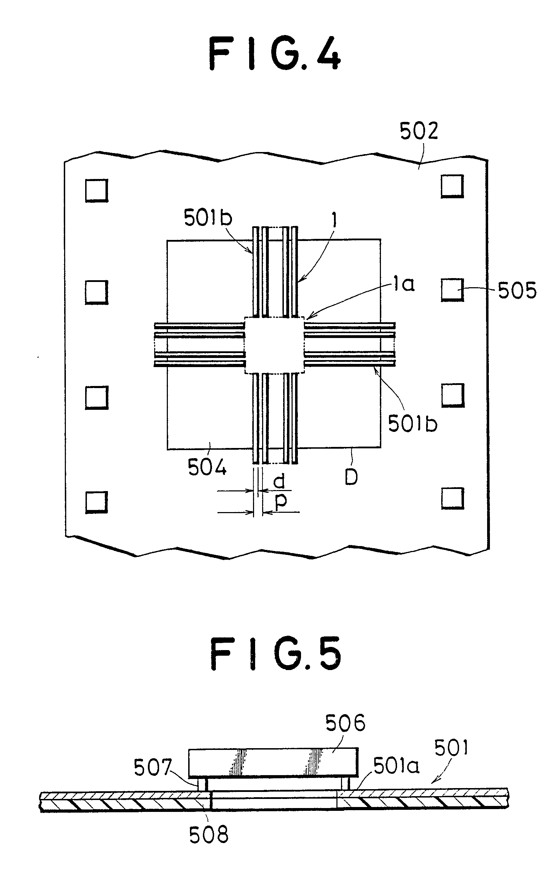

A senond embodiment of the present invention will now be described. In this embodiment, a tape carrier prepared in the same manner as the first embodiment is further processed so that a thin-section portion 208 is formed in the second area containing the portion of a flexible tape 202 where inner leads 201a are formed as shown in Fig.3.

In the second embodiment, the two sides of the flexible tape 202 are protected with an alkali-proof etching resist excluding an area C (i.e., the second area but not limited thereto) in the back side of the tape 202 in Fig.3 and then the tape 202 is rinsed after it has been immeresed in a 5-normality potassium hydroxide solution at 50˚ C for 1 hour.

As a result, the remaining polyimide thickness becomes 9 μm in the area unprotected by the etching resist.

In other words, in the present embodiment the thickness of the second area in the flexible tape 202 is reduced by the wet etching from the back side of the tape 202 (the opposite side to the paper plane) thereby forming the thin-section portion 208 (the area C in Fig 3).

In this embodiment the thin-section portion 208 is as thin as 9 μm and thus there is no danger of the inner leads 201a being deformed due to the thermal stresses during the bonding, thereby ensuring excellent bonding performance and stability after the connection.

On the other hand, in the second embodiment a thin-section portion is formed by the same forming process as the inner leads 201a in the portion corresponding to the outer lead hole 4 in Fig.3 so that the metal wires of the outer leads are made finer and the required stength for the connection wires to the terminals of an external circuit device is maintained, therby ensuring enhanced bonding performance irrespective of the finer wires.

It is to be noted that in the present embodiment the flexible tape member comprises the "NOVAX", the trademark of Mitsubishi Kasei Kogyo Co., Ltd., and this is due to the fact that the material is excellent in etching properties and it is also semitransparent, thus making it easy to perform image processing, etc., for the alignment during the bonding.

Therefore, if any other product is used for the flexible tape member, the etching conditions, etc., are changed.

It is to be noted that while, in this embodiment of the invention, the semiconductor device chip 206 is positioned on that side of the tape 202 where the metal wires 201 are formed, the invention is not limited thereto. For instance, the semiconductor device chip 206 can be arranged on the back side of the thin film portion by such method of forming holed leading from the back side portion in the thin-section portion 208 to the metal wires 201 forming the inner leads 201a and extending protruding electrodes composed conductors connected to the metal wires into the holes.

Using the tape carrier prepared in the above-mentioned way, as shown by the enlarged sectional view of Fig.3 showing the device hole 203 and the surroundings, the inner leads 201a and the bumps 207 of the semiconductor device chip 206 were bonded with the result that due to the inner leads 201a being reinforced by the thin-section portion 208 of the flexible tape 202, there was no bending of the inner leads 201a due to the application of pressure.

In addition, in the present embodiment there is provided the opening 203 having the same function as the device hole so that where a resin molding at the product stage is to be effected, there is the advantage that a bonding molding resin can be poured by using the opening 203 as the device hole, thereby simplifying the operation.

A third embodiment of the present invention will be described with respect to the lead strength of metal wires reinforced and supported by a flexible film member. Figs.4 and 5 are respectively a partial plan view and partial sectional view of a tape carrier according to the third embodiment of the present invention. In this embodiment, an area D containing outer leads 501b of metal wires 501 serves as the previously mentioned first and second areas and a flexible tape 502 within the area D is removed by substantially the same method as mentioned previously, thereby reinforcing the metal wires 501 by a thin-section area 508 alone as shown in Fig.5.

Also, in this embodiment a polyimide resin film is used as the flexible film member 502 and copper is used for the metal wires 501. The section thickness of the metal wires 501 and the thickness of the thin-section area 508 of the film 502 are each selected 7 μm and tin plating of 0.5 μm is further applied to the surface of the metal wires 501.

Using the tape carrier of the third embodiment, the inner leads 501a and the terminals of a semiconductor device chip 506 were bonded as shown in Fig.5 (an enlarged sectional wiew of the device hole and the surroundings) with the result that the inner leads 501a were not bent at all under the application of pressure due to their being reinforced and supported by the thin-section area 508 and the bonding properties were excellent.

The strength of the metal wires (the leads) reinforced by the thin-section area according to the present embodiment will now be explained.

For the purpose of comparison with the present embodiment, the following two samples (A) and (B) (the application of tin plating of 0.5 μm was effected in both of them) were used.

Sample (A)

This sample was the same as the present embodiment with respect to the forming method and size of the metal wires but it was equipped with no reinforcing and supporting portion.

Sample (B)

In this sample, a copper foil of 18 μm thick was used as the raw film and the thickness of the metal wires was selected 18 μm. No reinforcing and supporting portion was formed.

For each of these chip carrieres, the tensile strength of the leads was measured by bonding the inner leads of the metal wires to a semiconductor chip with 44 gold bumps and then bonding the outer leads to the connection points on a glass-epoxy substrate.

The results were as follows.

| | | Lead Structure | Breaking Strength (g) |
|---|---|---|---|
| Embodiment | 7 μm heat resistance | | X = 20.8 |
| | polyimide + 7 μm Cu + 0.5 μm Sn | | ($\rho$ = 0.32) |
| (B) | 7 μm Cu + 0.5 μm Sn | | X = 7.1 |
| | | | ($\rho$ = 0.28) |
| (C) | 18 μm Cu + 0.5 μm Sn | | X = 18.4 |
| | | | ($\rho$ = 0.42) |

All the test samples were 50 μm in lead width and the number of the measured samples was 88.

As will be seen from the above Table, it is evident that in the product of the present embodiment the strength of the leads is about three times that of the product of (A) including only the metal wires of the same thickness and it is also greater than that of the product of (B) including only the metal wires of about 2.5 times in thickness.

From the foregoing it will be seen that in accordance with the present embodiment the desired lead strength is maintained even if the metal wires are reduced in thickness.

It is to be noted that while, in the present embodiment, the copper metal wires are formed, the metal wires according to the present invention are not limited to copper and it is needless to say that the metal wires may be of a two-layer structure of copper and any other metal or they are composed of only any other metal than copper.

Next, an example of application of the tape carriers produced according to the first to third embodiments of the invention will be descrived as a fourth embodiment.

First, a semiconductor device chip is mounted in each of the plurality of device foles in the tape carrier by the conventional technique, thereby forming a plurality of successive semiconductor devices on the tape. The tape carrier is cut to separate the semiconductor devices into individual units, and the outer leads on one side of the thus produced elemental semiconductor device are electrically connected to the input terminals of an electrode board of a liquid crystal panel for forming a display device. An anisotropic electroconductive glue is used for the electrical connections. Also the outer leads on the other side of the semiconductor device are electrically connected to the terminals of a circuit board for driving and controlling the liquid crystal panel. The same type of the anisotropic electroconductive glue is used for these electric connections. Then, a liquid crystal display unit is assembled by using the liquid crystal panel thereby producing a liquid crystal display unit which is highly reliable against the occurrence of breaks, etc., and excellent in performance.

It is to be noted that while the fourth embodiment shows the case in which the semiconductor device using the chip carrier according to the invention is applied to a liquid crystal display unit, it is needless to say that the semiconductor device is equally applicable to other display units such as a plasma display unit and an electroluminescent desplay unit.

8

**Claims**

1. A clip carrier comprising :
a flexible film member (2 ; 202 ; 502) ;
at least one chip mounting area formed in said flexible film member; and
a plurality of groups of metal wires (1;201;501) including inner leads (1a;201a;501a) to be connected to terminals of a semiconductor device chip (6;206;506) to be mounted said plurality of groups of metal wires being formed on one side of said flexible film member to extend radially toward said chip mounting area,
each of said metal wires including at least one of said inner leads and being formed on said flexible film member,
said flexible film member including an opening (3;203) in a limited first area thereof containing said inner leads, said opening being formed in a portion (A) of said first area lying between said metal wires and internally of forwards ends of said inner leads.

2. A chip carrier according to claim 1, wherein said flexible film member is reduced in thickness on the opposite side to said one side including said metal wires in a second area (B) thereof containing said inner leads around said opening, and wherein said film member has a relatively small thickness in said second area in relation to a third area (C) thereof around said second area.

3. A chip carrier according to claim 1, wherein said film member is in the form of a long flexible tape, and wherein a plurality of rows of said chip mounting areas are arranged in said tape whereby said plurality of groups of metal wires are arranged for each of said mounting areas.

4. A combination of a chip carrier according to claim 1, a semiconductor device chip and a display device, wherein said semiconductor device chips mounted on said chip carrier,and wherein said semiconductor device chip and said display unit are electrically interconnected through said metal wires of said chip carrier, whereby said combination forms a display unit.

5. A combination according to claim 4, wherein said display device includes a liquid crystal panel.

# FIG.1

# FIG.2

# FIG.3

# F I G.4

# F I G.5